(19) Europäisches Patentamt
European Patent Office
Office européen des brevets

(11) **EP 2 633 555 B1**

(12) **EUROPÄISCHE PATENTSCHRIFT**

(45) Veröffentlichungstag und Bekanntmachung des Hinweises auf die Patenterteilung:
**04.12.2019 Patentblatt 2019/49**

(51) Int Cl.:
*H01L 27/06* *(2006.01)*        *H03K 17/30* *(2006.01)*
*H03K 17/567* *(2006.01)*       *H03K 17/74* *(2006.01)*

(21) Anmeldenummer: **11776372.2**

(22) Anmeldetag: **28.10.2011**

(86) Internationale Anmeldenummer:
**PCT/EP2011/005462**

(87) Internationale Veröffentlichungsnummer:
**WO 2012/055570 (03.05.2012 Gazette 2012/18)**

(54) **DIODENSCHALTUNG**

DIODE CIRCUIT

CIRCUIT À DIODE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.10.2010  DE 102010049705**

(43) Veröffentlichungstag der Anmeldung:
**04.09.2013   Patentblatt 2013/36**

(73) Patentinhaber:
• **AZURSPACE Solar Power GmbH**
  **74072 Heilbronn (DE)**
• **Institut für Mikroelektronik Stuttgart**
  **70569 Stuttgart (DE)**

(72) Erfinder:
• **SÖNMEZ, Ertugrul**
  **89075 Ulm (DE)**
• **KUNZE, Mike**
  **89250 Senden (DE)**
• **DAUMILLER, Ingo**
  **88451 Dettingen (DE)**

(74) Vertreter: **Witte, Weller & Partner Patentanwälte mbB**
**Postfach 10 54 62**
**70047 Stuttgart (DE)**

(56) Entgegenhaltungen:
WO-A1-2010/081530        US-A1- 2005 189 561
US-A1- 2007 176 291      US-A1- 2009 166 677
US-A1- 2009 189 191      US-A1- 2009 278 513

EP 2 633 555 B1

**Beschreibung**

Die Erfindung betrifft eine Diodenschaltung mit einem selbstleitenden Transistor und einer Diode, die in Sperrrichtung die Vorteile eines Transistors und in Durchlassrichtung die Vorteile einer Diode.

Transistoren werden in Schaltungen zur Steuerung eines Stromflusses verwendet. In geschalteten Anwendungen dienen sie als elektronische Schalter, um den Stromfluss zu gewähren oder zu blockieren. Abhängig vom Entwurf und den im Transistor verwendeten Halbleitermaterialien haben Transistoren üblicherweise einen nicht gewünschten Serienwiderstand in eingeschaltetem Zustand sowie eine bestimmte Isolierfestigkeit bis zu einer charakteristischen Spannung im ausgeschalteten Zustand.

Befindet sich ein Transistor im nicht-gesteuerten Zustand (wenn also keine Gate-Spannung angelegt ist) im ausgeschalteten Zustand, so wird er als selbstsperrend bezeichnet. Befindet er sich hingegen im ungesteuerten Zustand im zumindest teilweise eingeschalteten Zustand, so spricht man vom selbstleitenden Typ.

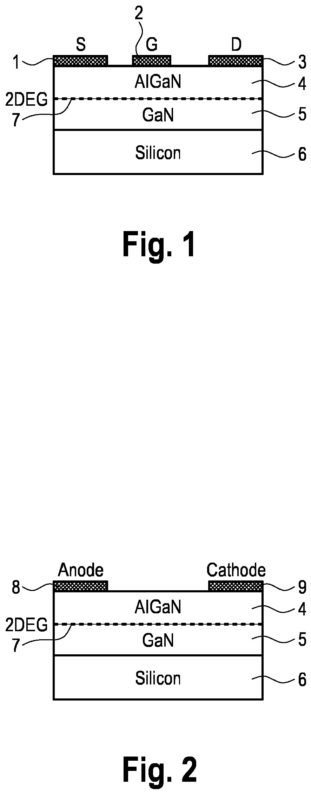

Ein Beispiel eines selbstleitenden Transistors ist ein AlGaN/GaN-HEMT-Transistor, wie er beispielhaft in Figur 1 gezeigt ist. In einem solchen Transistor bilden sich an einer Grenzfläche zwischen einer AlGaN-Schicht 4 und einer GaN-Schicht 5 ein zweidimensionaler Elektronensee 7 (2DEG) aus, der durch ohmsche Kontakte Source 1 S und Drain 3 D kontaktiert ist. Eine Gate-Elektrode 2 G kann durch einen Schottky-Kontakt hergestellt werden, über den durch Anlegen einer Spannung der Transistor steuerbar ist. Die Gate-Elektrode kann auch als Metall-Isolator-Halbleiter (MIS-Kontakt) ausgeführt sein. Aufgrund des zweidimensionalen Elektronensees ist der Transistor in der Standardkonfiguration vom selbstleitenden Typ. Durch Anlegen einer geeignet negativen Gate-Source-Spannung wird der durch den zweidimensionalen Elektronensee 7 erzeugte Kanal abgeschnürt und der Transistor in den isolierenden Betriebszustand versetzt.

Allgemein haben selbstleitende Transistoren eine negative Threshold-Spannung $V_{th} < 0$ V. Die Threshold-Spannung ist dabei jene Spannung, unterhalb derer der Transistor ausgeschaltet ist, also auf seiner Source-Drain-Strecke keinen Strom fließen lässt und oberhalb derer der Transistor eingeschaltet ist, so dass auf der Source-Drain-Strecke ein Strom fließen kann. Im vorstehend beschriebenen AlGaN/GaN-Transistor mit hoher Elektronenbeweglichkeit wird also bei Anlegen einer hinreichend negativen Spannung, die negativer ist als die Threshold-Spannung, der Kanal abgeschnürt und dadurch der Transistor ausgeschaltet.

Ein dem Transistor ähnliches Bauteil ist die Diode. Dioden können beispielsweise auf Silizium-Halbleitern oder auch auf AlGaN/GaN-Halbleitersystemen basieren.

Dioden, die keinen p-n-Übergang haben, sondern auf einem Metall-Halbleiter-Übergang basieren, werden als Schottky-Dioden bezeichnet. Die Grenze zwischen dem Metall und dem Halbleiter stellt dabei einen Schottky-Kontakt dar, der ähnlich wie bei einer p-n-Diode einen gleichrichtenden Charakter der Diode bewirkt. Schottky-Dioden zeigt in der Abhängigkeit des fließenden Stroms von der angelegten Spannung ähnliche Charakteristiken wie p-n-Dioden in der Diodenkennlinie. Insbesondere sind sie im Wesentlichen stromundurchlässig, wenn die angelegte Spannung kleiner ist als eine charakteristische Spannung. Oberhalb der charakteristischen Spannung werden die Dioden leitfähig mit einem bestimmten Widerstand $r_D$.

In US 2009/0278513 A1 ist ein selbstsperrender Schalter offenbart, mit einer Schottky-Diode, die mit einem selbstleitenden III-Nitrid-Bauelement in Reihe geschaltet ist. Die Anode der Schottky-Diode ist mit dem Gate des III-Nitrid-Bauelements verbunden, und die Kathode der Schottky-Diode ist mit der Source des III-Nitrid-Bauelements verbunden. Die Schottky-Diode kann zum Beispiel eine Niederspannungs-Siliziumdiode sein.

US 2009/0189191 A1 offenbart eine Halbleitervorrichtung mit einem GaN-basierten Transistor und einer Diode aus einem Halbleitermaterial mit kleinerer Bandlücke als GaN. Die Kathodenelektrode der Diode ist mit der Sourceelektrode des Transistors verbunden, und die Anodenelektrode der Diode ist mit der Gateelektrode des Transistors verbunden.

US 2009/0166677 A1 beschreibt in einem Ausführungsbeispiel die Integration einer Diode und eines Heteroübergangs-Transistors (HFET) in einem Laminat aus Nitridhalbleiterschichten.

WO 2010/081530 A1 beschreibt einen selbstsperrenden Schalter mit einem selbstleitenden Transistor, dessen Source-Kontakt mit einem nichtlinearen Element, z. B. einer Diode, verbunden ist. Der Transistor kann ein AlGaN/GaN-Transistor sein, und die Diode kann eine AlGaN/GaN-Diode sein, deren charakteristische Spannung nur vom Aluminium-Molgehalt in der AlGaN-Schicht abhängig ist.

Aufgabe der vorliegenden Erfindung ist es, eine Diodenschaltung anzugeben, die sich wie eine Diode verhält, die in Durchlassrichtung eine niedrige Durchlassspannung und niedrige parasitäre Widerstände aufweist und in Sperrrichtung eine hohe Sperrspannungsfestigkeit hat.

Diese Aufgabe wird gelöst durch die Diodenschaltung nach Anspruch 1.

Erfindungsgemäß wird eine Diodenschaltung angegeben, die zwischen einem äußeren Anodenkontakt und einem äußeren Kathodenkontakt die Funktionen einer Diode realisiert. Die erfindungsgemäße Diodenschaltung weist zumindest einen selbstleitenden Transistor und zumindest eine Diode auf. Ein Drain-Kontakt des Transistors ist mit dem äußeren Kathodenkontakt der Diodenschaltung elektrisch kontaktiert, an diesen angeschlossen oder stellt diesen dar. Ein Gate-Kontakt des Transistors ist an einen Anoden-kontakt der besagten Diode angeschlossen bzw. steht mit diesem in elektrischem, vorzugsweise unmittelbarem Kontakt. Darüber hinaus ist der Gate-Kontakt des Transistors und der Anodenkontakt der Diode an einen äußeren Anodenkontakt der Diodenschaltung angeschlossen bzw. bilden diesen äußeren Anodenkontakt.

Diese Schaltung erlaubt es, zwischen der externen Kathode und der externen Anoden eine Diode nachzubilden, die eine charakteristische Spannung $V_c$ der internen Diode und unabhängig von dieser Diode eine Sperrspannung des selbstleitenden Transistors T haben kann. Diese Schaltung ermöglicht es, die Diode für niedrige Durchlassspannungen und den Transistor auf niedrige parasitäre Widerstände in Verbindung mit hoher Sperrspannungsfestigkeit unabhängig zu optimieren. Die Schaltung soll im Folgenden auch als DT- Diode bezeichnet werden.

In der erfindungsgemäßen Diodenschaltung ist ein Source-Kontakt des Transistors an eine Kathode der Diode angeschlossen.

Sofern hier von Source-, Drain- und Gate-Kontakt die Rede ist, sind dieses die fachüblichen Bezeichnungen dieser Kontakte, wobei Source als Quelle, Drain als Senke und Gate als Gatter übersetzbar ist.

Die erfindungsgemäße Diodenschaltung ist mit einem AlGaN/GaN-Feldeffekttransistor mit hoher Elektronenbeweglichkeit (High Electron Mobility Transistor, HEMT) realisiert. Ein solcher weist eine AlGaN aufweisende Halbleiterschicht und eine GaN aufweisende Halbleiterschicht auf, die so ausgestaltet und angeordnet sind, dass sich zwischen diesen beiden Halbleiterschichten ein zweidimensionaler Elektronensee (2DEG) ausbildet, der dem Transistor als Kanal dient. Das Schichtsystem ist hierbei auf einem Siliziumsubstrat angeordnet, wobei die GaN-Schicht dem Siliziumsubstrat zugewandt ist, während die AlGaN- Schicht auf jener dem Siliziumsubstrat abgewandten Seite der GaN-Schicht angeordnet ist und auf ihrer der GaN abgewandten Oberfläche den SourceKontakt, den Gate-Kontakt und den Drain-Kontakt aufweist. Dabei kann der Gate-Kontakt in der einfachsten Ausführungsform zwischen dem Source-Kontakt und dem Drain-Kontakt angeordnet sein, so dass ein von ihm ausgehendes elektrisches Feld infolge einer angelegten Steuerspannung den Stromfluss zwischen Source- und Drain-Kontakt im zweidimensionalen Elektronensee beeinflusst.

Der Source-Kontakt und der Drain-Kontakt sind als Ohmsche Kontakte ausgebildet, während die Gate-Elektrode durch einen Schottky-Kontakt oder eine Metall-Isolator-Halbleiter Kontakt gebildet werden kann.

Erfindungsgemäß wird eine Diode verwendet, die auf einem AlGaN/GaN-Halbleitersystem basiert. Eine solche Diode weist eine AlGaN-enthaltende Halbleiterschicht sowie eine GaN-enthaltende Halbleiterschicht auf, die so ausgestaltet und angeordnet sind, dass sich zwischen ihnen ein zweidimensionaler Elektronensee ausbildet. Wiederum ist die AlGaN/GaN- Heterostruktur auf einem Siliziumsubstrat angeordnet, wobei wie im vorstehend beschriebenen Transistor die GaN-Halbleiterschicht dem Siliziumsubstrat zugewandt ist, während die AlGaN-Halbleiterschicht auf jener dem Siliziumsubstrat abgewandten Seite der GaN-Schicht angeordnet ist und auf ihrer der GaN- Schicht abgewandten Oberfläche den Anodenkontakt und den Kathodenkontakt trägt. Dabei ist der Anodenkontakt der Diode als Schottky-Kontakt ausgestaltet und der Kathoden-Kontakt als Ohmscher Kontakt.

Auf einer AlGaN/GaN-Heterostruktur basierende Dioden sind für die erfindungsgemäße Diodenschaltung deshalb vorteilhaft, weil sie mit einem AlGaN/GaN-Transistor mit gemeinsamen Halbleiterschichten realisierbar sind. Der Transistor und die Diode weisen daher zumindest eine gemeinsame GaN-Halbleiterschicht auf.

In einer vorteilhaften Ausgestaltung dieser Ausführungsform können auf der gemeinsamen GaN-Halbleiterschicht, die im Folgenden als gemeinsame Halbleiterschicht bezeichnet wird, eine Vielzahl von Dioden mit jeweils einer ersten AlGaN-Halbleiterschicht oder mit einer gemeinsamen ersten AlGaN-Halbleiterschicht angeordnet sein. Es ist also auf der gemeinsamen Halbleiterschicht für jede der Dioden eine eigene AlGaN-Halbleiterschicht angeordnet oder für mehrere oder alle Dioden eine gemeinsame AlGaN-Schicht. Vorteilhafterweise sind dabei diese Dioden parallel zueinander auf der gemeinsamen Halbleiterschicht angeordnet, so dass also ihre jeweiligen Strecken zwischen Anode und Kathode nebeneinander und parallel zueinander verlaufen.

Darüber hinaus ist auf der gemeinsamen Halbleiterschicht eine der Zahl der Dioden entsprechende Zahl von Transistoren angeordnet, die jeweils mit einer zweiten AlGaN-Halbleiterschicht realisiert sein können oder einer gemeinsamen zweiten AlGaN-Halbleiterschicht. Vorzugsweise sind die Transistoren mit ihren Source-Drain-Strecken parallel zueinander nebeneinander angeordnet. Besonders vorteilhaft ist es, wenn jeweils ein Transistor und eine Diode so angeordnet sind, dass der Anoden- und der Kathodenkontakt der entsprechenden Diode und der Source- und der Drain-Kontakt des entsprechenden Transistors alle auf einer gemeinsamen Geraden liegen. Jeweils eine Diode bildet mit dem entsprechenden Transistor eine elementare Diodenschaltung im Sinne der Erfindung.

Der äußere Anodenanschluss und der äußere Kathodenanschluss der Diodenschaltung kann hierbei ein gemeinsamer für alle Transistoren bzw. Dioden sein.

In dieser Ausgestaltung der Erfindung ist jeweils ein Transistor mit einer ihm zugeordneten Diode wie vorstehend beschrieben kontaktiert. Diese Ausgestaltung der Erfindung kann daher auch als Diodenbauelement mit einer Vielzahl von Diodenschaltungen wie vorstehend beschrieben angesehen werden.

Sofern auf der gemeinsamen Halbleiterschicht eine Vielzahl von Transistoren und Dioden angeordnet ist, sind diese vorzugsweise mit einem rechteckigen Querschnitt in einer Ebene parallel zum Substrat bzw. der gemeinsamen Halbleiterschicht ausgestaltet und jeweils mit parallelen Kanten dieses Querschnitts nebeneinander angeordnet.

Die Dioden und Transistoren können optional gleich breit sein. In diesem Falle können jeweils die Kanten eines Transistors auf einer gemeinsamen Geraden mit der entsprechenden Kante einer Diode liegen. Dioden und Transistoren können aber auch unterschiedliche Abmessungen haben.

Entsprechende Kanten aller Transistoren können optional auf einer gemeinsamen Geraden liegen und/oder entsprechende Kanten aller Dioden können optional auf einer gemeinsamen Geraden liegen.

Im Folgenden soll die Erfindung anhand einiger Figuren beispielhaft erläutert werden. Gleiche Bezugszeichen entsprechen dabei gleichen oder entsprechenden Merkmalen. Die in den Beispielen beschriebenen Merkmale können auch unabhängig vom konkreten Beispiel realisiert sein und unter den Beispielen kombiniert werden, soweit nicht anders beschrieben.

Es zeigt

Figur 1     einen Querschnitt durch einen AlGaN/GaN-Transistor,

Figur 2     einen Querschnitt durch eine AlGaN/GaN-Diode,

Figur 3     eine Diodenkennlinie einer GaN-Diode,

Figur 4     eine schematische Transferkennlinie eines GaN HEMTs,

Figur 5     ein Schaltbild einer erfindungsgemäßen Diodenschaltung,

Figur 6     eine Kennlinie der erfindungsgemäßen Diodenschaltung,

Figur 7     einen Querschnitt durch eine Realisierung der erfindungsgemäßen Diodenschaltung mit einer gemeinsamen Halbleiterschicht, und

Figur 8     ein vorteilhaftes Layout für die in Figur 7 gezeigte Realisierung der erfindungsgemäßen Diodenschaltung.

Figur 1 zeigt ein Beispiel eines AlGaN/GaN-Transistors mit hoher Elektronenbeweglichkeit (High Electron Mobility Transistor, HEMT). Hierbei ist auf einem Substrat 6 eine erste Halbleiterschicht 5 angeordnet, die GaN aufweist oder daraus besteht. Auf dieser ist auf jener dem Substrat 6 abgewandten Seite eine zweite Halbleiterschicht 4 angeordnet, die AlGaN aufweist oder daraus besteht. Zwischen der ersten Halbleiterschicht 5 und der weiteren Halbleiterschicht 4 bildet sich ein zweidimensionaler Elektronensee (2DEG) 7 aus, der in dem Transistor als Kanal fungiert.

Auf jener dem Substrat 6 abgewandten Oberfläche der weiteren Halbleiterschicht 4 sind die Transistorkontakte Source 1, Gate 2 und Drain 3 angeordnet, wobei der Gate-Kontakt 2 zwischen dem Source-Kontakt 1 und dem Drain-Kontakt 3 angeordnet ist. Wird einem Gate-Kontakt 2 eine Spannung zwischen Gate und Drain angelegt, so wirkt diese auf den zweidimensionalen Elektronensee 7. Ist die an die Gate-Elektrode 2 angelegte Spannung negativer als eine Threshold-Spannung $V_{th}$,

wird der Kanal abgeschnürt und der Transistor in den isolierenden Betriebszustand versetzt, indem kein Strom zwischen Source 1 und Drain 3 fließt. Der Source-Kontakt 1 und der Drain-Kontakt 3 des Transistors sind als Ohmsche Kontakte realisiert, während der Gate-Kontakt 2 ein Schottky-Kontakt oder ein MIS-Kontakt sein kann.

Figur 2 zeigt einen Querschnitt durch eine GaN-Diode, wie sie auch in der erfindungsgemäßen Diodenschaltung zum Einsatz kommen kann. Die Diode basiert auf einer Heterostruktur, die der in Figur 1 für den Transistor gezeigten Heterostruktur entspricht. Auf einem Substrat 6, das beispielsweise Silizium aufweisen kann oder daraus bestehen kann, ist zunächst eine GaN aufweisende oder daraus bestehende Schicht 5 angeordnet, auf welcher wiederum eine AlGaN aufweisende oder daraus bestehende Schicht 4 angeordnet ist. Auch hier bildet sich zwischen der GaN-Schicht 5 und der AlGaN-Schicht 4 ein zweidimensionaler Elektronensee (2DEG) 7 aus, der die Leitfähigkeit der Diode bewirkt. Auf jener dem Substrat 6 abgewandten Oberfläche der AlGaN-Schicht 4 ist eine Anode 8 angeordnet, die als Schottky-Kontakt realisiert ist sowie eine Kathode 9, die als ohmscher Kontakt realisiert ist. Die charakteristische Spannung $V_c$ wird durch den Typ des Anodenkontaktmetalls beeinflusst bzw. eingestellt.

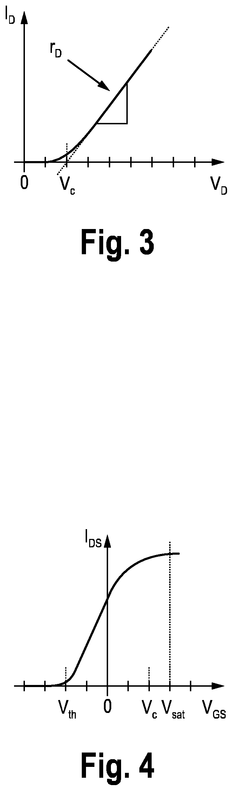

Figur 3 zeigt eine Diodenkennlinie einer GaN-Diode, wie sie in Figur 2 gezeigt ist. Dabei ist auf der horizontalen Achse die zwischen Anode und Kathode der Diode angelegte Spannung VD aufgetragen, während auf der vertikalen Achse der durch die Diode fließende Strom ID aufgetragen ist. Es ist zu erkennen, dass bei Spannungen kleiner als einer charakteristischen Spannung $V_c$ kein Diodenstrom ID fließt. Bei Spannungen VD größer als die charakteristische Spannung $V_c$ wächst der Diodenstrom ID mit steigender Spannung VD linear an, wobei die Steigung des Anstiegs gerade dem Diodenwiderstand $r_D$ entspricht. Die charakteristische Spannung $V_c$ ist gerade jene Spannung, bei der eine mit dem linearen Bereich der Kennlinie zusammenfallende Gerade die horizontale Achse $I_D = 0$ schneidet.

Figur 4 zeigt eine Transferkennlinie eines AlGaN/GaN- Transistors mit hoher Elektronenbeweglichkeit (HEMT). Dabei ist auf der horizontalen Achse die Gate-Spannung $V_{GS}$ aufgetragen, die zwischen Gate- und Source-Kontakt des Transistors angelegt wird. Auf der vertikalen Achse ist der Transistorstrom $I_{DS}$ aufgetragen, der zwischen Drain und Source des Transistors fließt. Es ist zu erkennen, dass, wenn die Gate-Spannung $V_{GS}$ negativer bzw. kleiner ist als eine Schwellenspannung $V_{th}$, kein Strom $I_{DS}$ durch den Transistor fließt. Bei Gate-Spannungen $V_{GS}$ oberhalb der Schwellenspannung $V_{th}$ steigt der Strom $I_{DS}$ zunächst an und geht ab einer Sättigungsspannung $V_{sat}$ in eine Sättigung über. Das bedeutet, dass der für größere Gate-Spannungen $V_{GS}$ im Wesentlichen nicht weiter ansteigt. Die charakteristische Spannung $V_c$ des Transistors ist jene Spannung, bei welcher die durch die Gate-Elektrode und den Elektronensee aufgespannte Schottky-Diode öffnet.

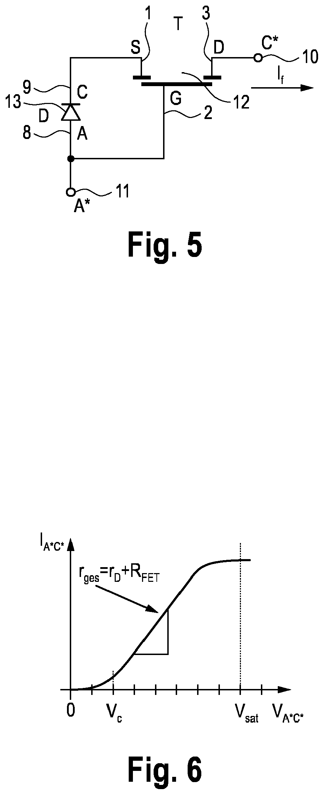

Figur 5 zeigt einen beispielhaften Schaltplan einer erfindungsgemäßen Diodenschaltung. Die Diodenschaltung weist einen Transistor 12 sowie eine Diode 13 auf, wobei der Transistor 12 ein GaN-basierter Transistor ist. Die Diode 13 ist eine GaN-Diode.

Die gezeigte Schaltung stellt zwischen einem äußeren Anodenkontakt 11 und einem äußeren Kathodenkontakt 10 die Funktion einer Diode zur Verfügung. In der Schaltung ist ein Gate-Kontakt 2 des Transistors 12 an einen Anodenkontakt 8 der Diode 13 angeschlossen, wobei der Anodenkontakt 8 und der Gate-Kontakt 2 beide an einen äußeren Anodenanschluss 11 der Diodenschaltung angeschlossen sind. Ein Drain-Kontakt 3 des Transistors ist an einen äußeren Kathodenkontakt 10 angeschlossen oder mit diesem identisch.

In der in Figur 5 gezeigten Schaltung ist außerdem ein Kathodenkontakt 9 der Diode 13 an einen Source-Kontakt 1 des Transistors 12 angeschlossen. Sofern die Diode 13 und der Transistor 12 als separate Bauelemente ausgestaltet sind, wird diese Verbindung der Kathode 9 mit dem Source-Kontakt 1 durch eine elektrisch leitfähige Verbindung realisiert. Werden jedoch der Transistor 12 und die Diode 13 in einer gemeinsamen Halbleiterstruktur realisiert, so kann diese Verbindung auch dadurch gegeben sein, dass die Kathode 9 der Diode 13 und der Source-Abschnitt des Transistors 12 durch denselben Bereich im Inneren der Halbleiterstruktur gegeben sind. In diesem Falle müssen sie nicht elektrisch miteinander verbunden werden.

Figur 6 zeigt eine Kennlinie der in Figur 5 gezeigten Diodenschaltung. Dabei ist auf der horizontalen Achse die zwischen äußerer Anode 11 und äußerer Kathode 10 angelegte Spannung $V_{A^*C^*}$ aufgetragen und auf der vertikalen Achse der zwischen der äußeren Kathode 10 und der äußeren Anode 11 fließende Strom $I_{A^*C^*}$. Die in Figur 5 gezeigte Schaltung bildet zwischen dem äußeren Kathodenkontakt 10 und dem äußeren Anodenkontakt 11 eine Diode nach, die eine charakteristische Spannung $V_c$ der internen Diode 13 und unabhängig von dieser Diode eine Sperrspannung des selbstleitenden Transistors 12 besitzt. Wie in der in Figur 3 gezeigten Diodenkennlinie ist die Diodenschaltung für kleine Spannungen $V_{A^*C^*}$ nicht leitend und steigt ab einer charakteristischen Spannung $V_c$ linear an. Die Steigung des linearen Anstiegs entspricht gerade dem parasitären Serienwiderstand der einzelnen Schaltungsbauelemente. Es addieren sich hierbei der Diodenwiderstand $r_D$ und der Widerstand des Transistors 12 zwischen Source-Kontakt 1 und Drain-Kontakt 3 RFET zum Gesamtwiderstand, so dass gilt $r_{ges} = r_D + R_{FET}$.

Ab einer angelegten Spannung $V_{A^*C^*}$ größer als eine Sättigungsspannung $V_{sat}$ geht die Diodenschaltung in einen gesättigten Bereich über.

Die in Figur 5 gezeigte erfindungsgemäße Diodenschaltung hat grundsätzlich drei Betriebsmodi, die sie in Abhängigkeit ihrer Klemmenspannung $V_{A^*C^*}$ einnimmt;

1.

$$V_{A^*C^*} < V_{th}$$

Für negativere Klemmenspannungswerte $V_{A^*C^*}$ als dem Wert der Threshold-Spannung $V_{th}$ des Transistors 12, die selbst negativ ist, befindet sich der Transistor 12 im ausgeschalteten Zustand. Die Diode 13 befindet sich im Sperrbetrieb und baut aufgrund ihrer Auslegung maximal eine Spannung von $V_D \approx V_{th}$ auf. Die Diodenspannung der Diode 13 überschreitet diesen Wert nicht, weil der Transistor 12 für negativere Klemmenspannungen als $V_{A^*C^*} < V_{th}$ durch die Diode 13 ausgeschaltet wird und der Transistor 12 die Restspannung $V_{A^*C^*} - V_{th}$ über seine Gate-Drain-Strecke abbaut. Die Diodenschaltung 12 befindet sich im sperrenden Betriebsmodus.

2.

$$V_{th} < V_{A^*C^*} < V_c$$

Für Klemmenspannungswerte $V_{A^*C^*}$ kleiner als die charakteristische Spannung $V_c$ und größer als die Threshold-Spannung $V_{th}$ des Transistors 12 befindet sich die Diode 13 im sperrenden und der Transistor 12 im leitenden Bereich. Für diesen Klemmenspannungsbereich reicht die Diodenspannung nicht aus, den Transistor 12 auszuschalten. Die Diodenschaltung befindet sich im sperrenden Betriebsmodus.

3.

$$V_{A^*C^*} > V_c$$

Für Klemmenspannungswerte $V_{A^*C^*}$ größer als die charakteristische Spannung $V_c$ befinden sich sowohl der Transistor 12 als auch die Diode 13 im leitenden Betriebsmodus. Die Diodenschaltung befindet sich im leitenden Betriebsmodus.

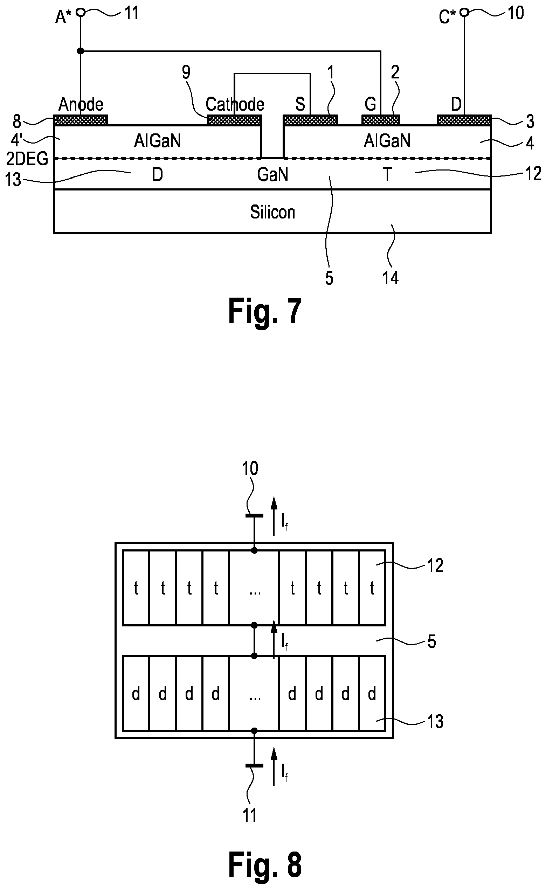

Figur 7 zeigt in einem Querschnitt ein Beispiel, wie die erfindungsgemäße Diodenschaltung monolithisch integriert hergestellt werden kann. Hierbei sind der Transistor 12 und die Diode 13 mit einer gemeinsamen GaN-Halbleiterschicht 5 realisiert, die im Folgenden als gemeinsame Halbleiterschicht bezeichnet wird und auf einem gemeinsamen Substrat 14 angeordnet ist. Die AlGaN-Schichten 4, 4' sind für Transistor und Diode getrennt ausgeführt. Beide AlGaN-Schichten 4 und 4' sind nebeneinander auf der gemeinsamen Halbleiterschicht 5 angeordnet. Auf jener der gemeinsamen Halbleiterschicht 5 abgewandten Oberseite der AlGaN-Schicht 4 des Transistors sind ein Source-Kontakt 1, ein Drain-Kontakt 3 sowie zwischen diesen ein Gate-Kontakt 2 aufgebracht. Auf jener der gemeinsamen Halbleiterschicht 5 abgewandten Oberseite der weiteren Halbleiterschicht 4' der Diode ist ein Anodenkontakt 8 aufgebracht, der ein Schottky-Kontakt ist sowie ein Kathodenkontakt 9, der ein ohmscher Kontakt ist. Der Drain-Kontakt 3 ist an den äußeren Kathodenanschluss 10 angeschlossen. Anodenkontakt 8 und Gate-Kontakt 2 sind miteinander kurzgeschlossen und gemeinsam mit dem äußeren Anodenschluss 11 verbunden. Die Kathode 9 ist elektrisch leitend durch eine Leitung mit dem Source-Kontakt 1 verbunden.

Der Schottky-Kontakt der Diode 13, welcher eine möglichst niedrige Barriere haben soll, bildet also die Anode der Diodenschaltung. Der Ohmsche Kontakt der Diode 13 ist mit dem Ohmschen Kontakt (Source) 1 des Transistors 12 kurzgeschlossen. Die Steuerelektrode (Gate) 2 des Transistors 12 ist mit der Anode 8 der Diode 13 kurzgeschlossen. Dieser Steuerkontakt kann auch über einen Schottky-Kontakt oder einen MIS-Kontakt realisiert werden, an den die Anforderung der möglichst niedrigen Barriere nicht gestellt werden muss. Damit der Vorwärts-Stromfluss über die Anode 8 und nicht über die Steuerelektrode 2 stattfindet, ist vorzugsweise dessen Austrittsarbeit höher als die des Anodenmaterials.

Figur 8 zeigt eine mögliche Integration der in Figur 7 dargestellten Realisierung der erfindungsgemäßen Diodenschaltung, in welcher die beiden Schaltungsbauelemente lateral auf der GaN-Schicht 5 ausgebildet sind.

Hierbei sind eine Vielzahl von Transistoren 12 nebeneinander angeordnet, die auf einer gemeinsamen AlGaN-Schicht 4 realisiert sein können oder jeweils auf einer AlGaN-Schicht 4. Jedem Transistor 12 kommt dabei ein rechteckiger Bereich der AlGaN-Schicht 4 zu bzw. eine rechteckige AlGaN-Schicht 4. Diese rechteckigen Bereiche sind auf der GaN-Schicht 5 parallel zueinander nebeneinander angeordnet. Die Transistoren 12 können dabei die Kontakte 1, 2 und 3 jeweils auf einer Geraden angeordnet aufweisen, wobei die durch die Kontakte 1, 2 und 3 definierte Strecken für alle Transistoren 12 parallel zueinander liegen.

Entsprechend sind auch die Dioden 13 auf einer gemeinsamen AlGaN-Schicht 4' oder jeweils auf einer eigenen AlGaN-Schicht 4' ausgebildet, die wiederum rechteckig ist. Auch die AlGaN-Schichten 4' der Dioden liegen mit parallelen Kanten nebeneinander. Jene durch die Anode 8 und die Kathode 9 definierte Strecke jeder Diode 13 ist vorzugsweise für alle Dioden 13 parallel.

Die Zahl der Transistoren 12 kann gleich der Anzahl der Dioden 13 sein. Im gezeigten Beispiel sind alle Anoden 8 der Dioden 13 durch eine gemeinsame äußere Anode 11 angeschlossen und alle Drain-Kontakte 3 der Transistoren an einem gemeinsamen äußeren Kathodenkontakt 10 angeschlossen.

In Figur 8 besteht zwischen den Transistoren einerseits und den Dioden andererseits ein Graben in der AlGaN-Schicht. Dieser bewirkt eine physikalische Trennung der Bauelemente (Transistor und Diode). Die Bauelemente können daher auch räumlich auf dem Wafer separiert angeordnet werden. Vorteilhaft können zunächst alle Dioden parallel geschaltet werden und räumlich getrennt alle Transistoren parallel geschaltet werden und dann die parallel geschalteten Bauelemente über einen Bus verbunden werden.

Die erfindungsgemäße Diodenschaltung kann in allen getakteten Spannungswandleranwendungen eingesetzt werden, wie in Abwärts-, Aufwärts-, Invertierender-, Sperr-, Eintakt-Durchfluss-, Halbbrücken-Durchfluss-, Halbbrücken-Gegentakt-, Vollbrückengegentakt-Wandlern und in Leistungsfaktor-Vorregelungen (PFC) .

Ihr Einsatz ist prädestiniert für (nach VDE- Vorschriften) Nieder- und Hochspannungsanwendungen aber auch für Hochtemperaturelektronik-Anwendungen (> 200 °C).

Die Anwendungsgebiete sind im Verbraucher-, Industrie-, Automotive- und Aerospace-Markt angesiedelt.

**Patentansprüche**

1. Diodenschaltung mit einem selbstleitenden Transistor (12) und einer Diode (13), wobei ein Drain-Kontakt (D) des Transistors einen äußeren Kathodenkontakt (C*) der Diodenschaltung bildet oder an einen solchen angeschlossen ist, ein Gate-Kontakt (G) des Transistors an einen Anoden-Kontakt (A) der Diode (13) angeschlossen ist und der Gate-Kontakt (G) des Transistors und der Anoden-Kontakt (A) der Diode an einen äußeren Anodenkontakt (A*) der Diodenschaltung angeschlossen ist, wobei ein Source-Kontakt (S) des Transistors an eine Kathode (C) der Diode angeschlossen ist,
**dadurch gekennzeichnet, dass**
der Transistor (12) und die Diode (13) eine gemeinsame GaN-Halbleiterschicht (5) aufweisen, die auf einem gemeinsamen Substrat (14) angeordnet ist; wobei die Diode (13) eine auf der gemeinsamen GaN-Halbleiterschicht (5) angeordnete erste AlGaN-Halbleiterschicht (4') aufweist, wobei die erste AlGaN-Halbleiterschicht (4') und die gemeinsame GaN-Halbleiterschicht (5) so ausgestaltet und angeordnet sind, dass sich zwischen ihnen ein zweidimensionaler Elektronensee (2DEG) ausbildet, und wobei auf jener der gemeinsamen GaN-Halbleiterschicht (5) abgewandten Oberseite der ersten AlGaN-Halbleiterschicht (4') der Anoden-Kontakt (A) der Diode und der Kathoden-Kontakt (C) der Diode angeordnet sind; wobei der Transistor (12) ein AlGaN/GaN-Feldeffekttransistor ist und eine auf der gemeinsamen GaN-Halbleiterschicht (5) angeordnete zweite, von der ersten getrennte, AlGaN-Halbleiterschicht (4) aufweist, wobei die zweite AlGaN-Halbleiterschicht (4) und die gemeinsame GaN-Halbleiterschicht (5) so ausgestaltet und angeordnet sind, dass sich zwischen ihnen ein weiterer zweidimensionaler Elektronensee (2DEG) ausbildet, und wobei auf jener der gemeinsamen Halbleiterschicht (5) abgewandten Oberseite der zweiten AlGaN-Halbleiterschicht (4) der Source-Kontakt (S), der Gate-Kontakt (G) und der Drain-Kontakt (D) angeordnet sind; und wobei der Anoden-Kontakt (A) der Diode ein Schottky-Kontakt ist, der Kathoden-Kontakt (C) der Diode ein Ohmscher Kontakt ist, der Source-Kontakt (S) des Transistors ein Ohmscher Kontakt und der Drain-Kontakt (D) des Transistors ein Ohmscher Kontakt ist.

## Claims

1. A diode circuit comprising a self conducting transistor (12) and a diode (13), wherein a drain contact (D) of the transistor forming or being connected to an outer cathode contact (C*) of the diode circuit, wherein a gate contact (G) of the transistor is connected to an anode contact (A) of the diode (13), and wherein the gate contact (G) of the transistor and the anode contact (A) of the diode are connected to an outer anode contact (A*) of the diode circuit, wherein a source contact (S) of the transistor is connected to a cathode (C) of the diode, **characterized in that** the transistor (12) and the diode (13) comprise a common GaN semiconductor layer (5) arranged on a common substrate (14); wherein the diode (13) comprises a first AlGaN semiconductor layer (4') disposed on the common GaN semiconductor layer (5), wherein the first AlGaN semiconductor layer (4') and the common GaN semiconductor layer (5) are formed and arranged, such that a two-dimensional electron lake (2DEG) is formed between them, and wherein the anode contact (A) of the diode and the cathode contact (C) of the diode are arranged on that upper side which faces away from the common GaN semiconductor layer (5) of the first AlGaN semiconductor layer (4'); wherein the transistor (12) is an AlGaN/GaN field effect transistor and comprises a second AlGaN semiconductor layer (4), that is separated from the first semiconductor layer and is arranged on the common GaN semiconductor layer (5), wherein the second AlGaN semiconductor layer (4) and the common GaN semiconductor layer (5) are formed and arranged, such that a further two-dimensional electron lake (2DEG) is formed between them, and wherein the source contact (S), the gate contact (G) and the drain contact (D) are arranged on that upper side which faces away from the common semiconductor layer (5) of the second AlGaN semiconductor layer (4); and wherein the anode contact (A) of the diode is a Schottky contact, the cathode contact (C) of the diode is an ohmic contact, the source contact (S) of the transistor is an ohmic contact, and the drain contact (D) of the transistor is an ohmic contact.

## Revendications

1. Circuit à diodes doté d'un transistor autoconducteur (12) et d'une diode (13), dans lequel un contact de drain (D) du transistor forme un contact de cathode externe (C*) du circuit à diodes ou est raccordé à un tel contact, un contact de grille (G) du transistor est raccordé à un contact d'anode (A) de la diode (13) et le contact de grille (G) du transistor et le contact d'anode (A) de la diode sont raccordés à un contact d'anode externe (A*) du circuit à diodes, dans lequel un contact de source (S) du transistor est raccordé à une cathode (C) de la diode, **caractérisé en ce que** le transistor (12) et la diode (13) comportent une couche semi-conductrice GaN (5), laquelle est agencée sur un substrat commun (14) ; dans lequel la diode (13) comporte une première couche semi-conductrice AlGaN (4') agencée sur la couche semi-conductrice GaN commune (5), dans lequel la première couche semi-conductrice AlGaN (4') et la couche semi-conductrice GaN commune (5) sont réalisées et agencées de telle sorte qu'il se forme entre les deux un gaz d'électrons bidimensionnel (2DEG), et dans lequel le contact d'anode (A) de la diode et le contact de cathode (C) de la diode sont agencés sur la face supérieure de la première couche semi-conductrice AlGaN (4') se détournant de la couche semi-conductrice GaN commune (5) ; dans lequel le transistor (12) est un transistor à effet de champ AlGaN/GaN et comporte une deuxième couche semi-conductrice AlGaN (4), séparée de la première, agencée sur la couche semi-conductrice GaN commune (5), dans lequel la deuxième couche semi-conductrice AlGaN (4) et la couche semi-conductrice GaN commune (5) sont réalisées et agencées de telle sorte qu'il se forme entre les deux un autre gaz d'électrons bidimensionnel (2DEG), et dans lequel le contact de source (S), le contact de grille (G) et le contact de drain (D) sont agencés sur la face supérieure de la deuxième couche semi-conductrice AlGaN (4) se détournant de la couche semi-conductrice commune (5) ; et dans lequel le contact d'anode (A) de la diode est un contact Schottky, le contact de cathode (C) de la diode est un contact ohmique, le contact de source (S) du transistor est un contact ohmique et le contact de drain (D) du transistor est un contact ohmique.

**Fig. 1**

**Fig. 2**

**Fig. 3**

**Fig. 4**

**Fig. 5**

**Fig. 6**

## Fig. 7

## Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20090278513 A1
- US 20090189191 A1
- US 20090166677 A1
- WO 2010081530 A1